# EUROPEAN PATENT APPLICATION

(11) **EP 4 852 635 A1**
(43) Date of publication of application: **09.12.2026**
(21) Application number: 25181213.7
(22) Date of filing: 05.06.2025
(51) Int. Cl.: H05K 7/20, H01L 23/367, H01L 23/42

(54) **HEAT SINK DEVICE**

(71) Applicant: Valeo Comfort and Driving Assistance, 94000 Créteil (FR)
(72) Inventor: GOEHRING, Tim, 94000 Créteil (FR); NIBBARAGANDLA, Rajinikanth-Reddy, 94000 Créteil (FR)
(74) Representative: Delaval, Guillaume Laurent

(57) **Abstract**

It is provided a heat sink device configured to dissipate heat of a vehicle telematic control unit (TCU). The heat sink device comprises a first face configured to be coupled to a heat emitting part of the telematic control unit. The heat sink device also comprises a second face configured to be coupled to a crossmember of the vehicle. The second face is opposite to the first face. The heat sink device also comprises at least one wall extending between the first face and the second face. The wall has attached a plurality of ribs extending outwardly from the heat sink.

## Description

### Technical field

The disclosure relates to the field of telematic control units, and more specifically to a heat sink device configured to dissipate heat of a vehicle telematic control unit (TCU). The disclosure also relates to a TCU comprising such a heat sink device, and to a vehicle comprising such a TCU.

### Background

A role of a telematic control unit (TCU) in a vehicle is to control wireless tracking, diagnostics and communications to and from the vehicle using an antenna system. Typically, a TCU is embedded onboard the vehicle.

TCUs are becoming more and more exigent in terms of computing power so as to satisfy vehicle communication requirements. Electronic vehicle components for the TCU therefore need to become more efficient while being as small as possible to satisfy the vehicle manufacturing design requirements but still fit the necessary amount of components within the TCU's housing.

When performing computations for communication requirements, electronic parts comprised in the TCUs generate heat and thereby heat the TCU assembly. When it is too high, such heat may reduce performance of the TCU.

Within this context, there is a need for a solution to manage heat generated within a TCU.

### Summary

It is thereby provided a heat sink device configured to dissipate heat of a vehicle telematic control unit (TCU). The heat sink device comprises a first face configured to be coupled to a heat emitting part of the telematic control unit. The heat sink device also comprises a second face configured to be coupled to a crossmember of the vehicle. The second face is opposite to the first face. The heat sink device also comprises at least one wall extending between the first face and the second face. The wall has attached a plurality of ribs extending outwardly from the heat sink.

In examples, the heat sink device may present any one or more of the following features:
- the first face has an area smaller than the second face, the wall extending from the first face to a portion of the second face, the portion of the second face having an area comprised between the area of the first face and the second face;
- the ribs extend outwardly so as to free space for components of the telematic control unit;
- wherein the first face consists of a plain surface and/or the heat sink device is of a constant material thickness (t) ;
- the second face comprises a plurality of holes, the plurality of holes extending towards the first face;
- the plurality of holes all reach a same distance (t) from the first face.
- the plurality of holes each present a cross-section having a same and constant width (t');
- the heat sink device is of a constant material thickness (t), and the constant material thickness (t) is equal to the width (t') of the cross-section of each hole of the plurality of holes;
- each hole of the plurality of holes has a rectangular parallelepiped shape;
- the plurality of holes forms an array on the second face;
- wherein the plurality of holes forms a grid on the second face; and/or
- the heat sink device is die-cast.

It is further provided a vehicle telematic control unit. The vehicle telematic control unit comprises a heat emitting part. The vehicle telematic control unit also comprises the heat sink device. The first face of the heat sink device is coupled to the heat emitting part.

The heat emitting part may comprise one or more processors and/or one or more printed circuit boards (PCBs).

It is further provided a vehicle. The vehicle comprises the vehicle telematic control unit. The vehicle also comprises a crossmember. The second face of the heat sink device is coupled to the crossmember.

### Brief description of the drawings

Non-limiting examples will now be described in reference to the accompanying drawings, where:
**FIG.s 1 to 22** shows examples of the heat sink device.

### Detailed description

It is provided a heat sink device configured to dissipate heat of a vehicle telematic control unit (TCU). The heat sink device comprises a first face configured to be coupled to a heat emitting part of the telematic control unit. The heat sink device also comprises a second face configured to be coupled to a crossmember of the vehicle. The second face is opposite to the first face. The heat sink device also comprises at least one wall extending between the first face and the second face. The wall has attached a plurality of ribs extending outwardly from the heat sink.

This improves the performance for reducing the core temperature of the heatsink. Indeed, the plurality of ribs extend the effective area for spreading the heat coming from the heat emitting part. In turn, performance of the heat emitting part of the telematic control unit can be improved as there is less need to throttle back the heat emitting part so as to keep temperature stable.

The heat sink device is configured to dissipate heat of the TCU. In other words, the heat sink device is configure to flow/conduct heat through its constituent elements, so as to enable heat dissipation into the ambient or into another object.

The TCU may be fixed to the crossmember. The TCU may for example comprise a housing, and the housing may be attached to the crossmember, for example with screws and/or bolts. The crossmember may be made of a composite material such as glass-fiber reinforced plastic (GFK) or carbon fiber (CFK).

The TCU may comprise a housing. The housing may be made of plastic. The housing may enclose the inside of the TCU. In particular, the housing may enclose the heat emitting part, such as the one or more processors and/or one or more PCBs. The housing may comprise an opening filled with the second face of the heat sink device, such that the second face forms part of the enclosure. The second face of the heat sink device may have a peripheral edge fixed to a corresponding edge of said opening of the housing, for example in an airtight manner and/or by over-moulding. For example, the heat sink device may be arranged as an insert when (e.g. plastic-) moulding the housing.

The thermal coupling at one or both of the first and second interfaces may be achieved with a thermal paste and/or a thermal adhesive applied at said interface. Such material increases heat exchange, as the thermal paste and/or thermal adhesive reduces or eliminates air gaps at the interface. The thermal paste may comprise, as an example, a polymerizable liquid matrix and an electrically insulating, but thermally conductive filler. The matrix material may comprise a material or a combination of materials selected from epoxies, silicones (silicone grease), urethanes, and acrylates, solvent-based systems, hot-melt adhesives, and pressure-sensitive adhesive tapes are also available. The filler material may comprise aluminium oxide, boron nitride, zinc oxide, and/or aluminium nitride are used as fillers for these types of adhesives. The thermal adhesive may comprise, as an example, a thermally conductive material and a glue. The glue may comprise a two-part epoxy resin or cyanoacrylate. The thermally conductive material may include any material or combination of materials selected from metals, metal oxides, silica or ceramic microspheres.

The heat sink device may be die-cast (i.e., obtained by a die-casting process). The heat sink device (including the ribs) may be obtained as a direct result of die-casting, without having to machine the heat sink device (in order for example to remove uneven areas due to sink marks coming from material agglomeration).

The heat sink device may be made of aluminium. Such a material is particularly light but still offers high heat conduction capacity. Aluminium further allows a simple die-casting process, as its melting point temperature is relatively low.

The first face is configured to be coupled to a heat emitting part of the TCU. The second face is configured to be coupled to a crossmember of the vehicle. By "coupled to", it is meant "thermally coupled to". In other words, it is meant that the first face, respectively second face, is configured to be arranged in direct or indirect contact with (for example pressed onto and/or attached to, directly or indirectly) a face of the heat emitting part, respectively of the crossmember, such that heat can flow across the respective interface through thermal conduction.

The second face is opposite to the first face. By "opposite", it is meant that the first face and the second face are arranged so as to form different (opposite) sides of the heat sink device, without the two faces necessarily being parallel one to another, though the two faces may optionally be parallel one to another. A virtual plane may thereby cross the heat sink device such that the first face and the second face are located apart from the plane and on respective opposite sides of the plane.

The heat sink device also comprises at least one wall extending between the first face and the second face. The at least one wall may be created by the same die-casting process. In other words, the at least one wall has an area connecting the first face with the second face.

The at least one wall has attached a plurality of ribs. By "rib" it is meant a structure of material having a larger longitudinal direction relative to a transversal dimension. The (e.g., one or more, e.g., a plurality) ribs extend outwardly from the heat sink. In other words, the ribs extrude from at least one wall, e.g., in a direction substantially parallel to the first face or the second face. The ribs may be have a predetermined spacing between each other so as to allow air to circulate between the ribs. The predetermined spacing may be set in any manner.

The ribs may extend outwardly so as to free space for components of the telematic control unit. In other words, the ribs may have a predetermined spacing that is complementary to the space occupied by surrounding components, e.g., inside the housing comprised by the TCU.The heat sink device is thus configured for heat emitted by the heat emitting part of the TCU to be flowed/conducted into the heat sink device across the first face, to be flowed/conducted from the first face to the second face, via the at least one wall, and to be flowed/conducted through the ribs. Moreover, heat may also be emitted into the crossmember across the second face. The at least one wall may be made of a material for flowing/conducting heat. As the at least one wall links the first face to the second face, the at least one wall enables the heat to be flowed/conducted from the first face to the second face within such at least one wall. The heat sink device thus forms a heat flow path from the heat emitting part of the TCU to the crossmember. The crossmember may then be arranged for dissipating the heat received from the second face in any manner. The crossmember may for example comprise one or more other faces arranged such that air inside the vehicle circulates around said one or more other faces, and the crossmember may thereby dissipate heat absorbed by the crossmember though convection.

Furthermore, as the ribs extrude from the at least one wall, heat is also flowed/dissipated outwardly via the ribs. Thereby, air circulating between the ribs enables an efficient dissipation of heat though convection.

The first face may have an area smaller than the second face. For example, the second face may have an area 10 percent larger than the first face or more. The wall may extend from the first face to a portion of the second face. In other words, the wall may link at least a portion of the first face with a portion of the second face. In examples, the at least one wall may be a planar surface. In other words, the at least one wall may extend diagonally from the first face to the second face. In examples, the at least one wall may be a curved, e.g., concave or convex surface or a combination thereof.

Having a first face having an area smaller than the second face enables a better heat exchange. Indeed, the heat is first dissipated from the first face of the heat sink device in contact with the heat emitting part, to the second face of the heat sink device and particularly to the first part of the second face. Then, the heat may be dissipated from the first part of the second face to the second part of the second face, so as to increase the contact area where the heat will be further finally exchanged from the second face of the heat sink device to the crossmember of the vehicle.

The at least one wall may comprise one or more gaps. Each gap may be configured so as to free space for components of the TCU. For example, the one or more gaps may have a shape complementary to the space occupied by a respective component of the TCU.

In examples, the heat sink device may comprise a plurality of walls. The plurality of walls may be arranged contiguously, e.g., being linked by respective edges. Each of the walls may also extend from the first face to a portion of the second face.

Moreover, as mentioned above, the device is die-cast. This facilitates the manufacturing and allows achieving a light heat sink device. In particular ,as the at least one wall extends from the between the first face and the second face, die-casting may be performed more efficiently, and reduce the quantity of material needed to manufacture the device.

The second face may comprise a plurality of holes. The plurality of holes may extend towards the first face. In other words, the second face presents cavities directed toward by the heat emitting part. Yet in other words, the heat sink device may present an alveoli structure when viewed from the second face. Thus, the coupling between the second face and the crossmember is discontinuous, as portions of the crossmember are not covered by material of the heat sink device, but are rather left uncovered as holes are formed in the material of the heat sink device.

The plurality of holes allows avoiding or reducing the presence of uneven areas due to sink marks or other material distribution defects, such as material agglomeration, and thus avoiding or reducing the need to machine the heat sink device. Indeed, uneven areas due to sink marks or other material distribution defects negatively affect heat flow capabilities. Thanks to the plurality of holes, the heat sink device may be obtained as the direct result of a moulding or injection-moulding process, such as a die casting process, with no or little post-moulding machining (in order to remove uneven areas due to sink marks or other material distribution defects). Yet, the presence of holes does not significantly impair the heat flow capabilities of the heat sink device, such that the heat sink device still presents a high heat dissipation capacity.

Besides, the plurality of holes allows reducing weight of the heat sink device, while ensuring a sufficient distance between the first face and the second face, such that heat does not remain and accumulate near the first face but is rather correctly dissipated towards the crossmember. Additionally, the plurality of holes facilitates the manufacturing of the heat sink device, as it allows for example that the heat sink device is die-cast.

Moreover, having a plurality of holes rather than a single hole ensures the presence of straight or substantially straight paths of material between the first face and the second face, and this improves heat transfer towards the crossmember.

The distance between the first face and the second face may be higher than 5mm (e.g., everywhere, in average, or at minimum). This allows a sufficient heat dissipation. To ensure a compact design, the distance between the first face and the second face may be lower than 30mm (e.g., everywhere, in average, or at minimum). The plurality of holes may extend from the second face towards the first face so as to (e.g., each or in average) cover at least 50% or 75% of the (e.g., local or average) distance between the first face and the second face.

A TCU for a vehicle is also provided which comprises a heat emitting part and such a heat sink device. The first face of the heat sink device is coupled to the heat emitting part. In particular, the first face of the heat sink device may be arranged in contact with one or more faces of the heat emitting part. The first face of the heat sink device may be of complementary shape to said one or more faces of the heat emitting part, so that the first face conforms to said one or more faces of the heat emitting part. The first face of the heat sink device may for example be planar.

The heat emitting part may comprise any component that emits heat, for example one or more components that each generate heat, and/or one or more component that each absorb heat (for example generated by another component) and re-emit such absorbed heat. The heat emitting part may for example comprise one or more processors (e.g., central processing units, i.e., CPUs) and/or one or more printed circuit boards (PCBs).

The first face of the heat sink device may be arranged in contact with one or more faces of the heat emitting part. The heat emitting part may for example comprise one or more (e.g., micro-) chips (e.g., each chip enclosing a processor), and the first face of the heat sink device may be arranged in contact with a -e.g., top- face of each chip (e.g., wherein in case the first face of the heat sink device is coupled to several chips in this manner, the -e.g., top- face of the several chips may be contained and aligned in a same plane). By "top" face of a chip, it is meant a face of the chip which is left accessible when the chip is connected to a PCB, as opposed to the "bottom" face of the chip which is the opposite face and mounted on the PCB. Alternatively or additionally, the heat emitting part may for example comprise one or more PCBs (e.g., each PCB being connected to one or more heat generating components, for example including one or more processors), and the first face of the heat sink device may be arranged in contact with a -e.g., bottom- face of the one or more PCBs (e.g., wherein in case the first face of the heat sink device is coupled to several PCBs in this manner, the -e.g., bottom face- of the several PCBs may be contained and aligned in a same plane). By "bottom" face of a PCB, it is meant a face of the PCB which is left accessible when the chip is connected to electronic components, as opposed to the "top" face of the PCB which is the opposite face and on which electronic components are mounted.

A vehicle is further provided which comprises such a TCU, for example a motor vehicle such as an automobile or car, a truck, a bus, a van, a campervan, or a motorcycle. The vehicle further comprises a crossmember. The second face of the heat sink device is coupled to the crossmember. In particular, the second face of the heat sink device may be arranged in contact with a face of the crossmember. The face of the crossmember to which the second face of the heat sink device is coupled may be planar or non-planar (for example curved), and/or of complementary shape to the second face of the heat sink device (which may thereby be planar or non-planar, for example curved). Thus, the second face conforms to the crossmember. A curved crossmember increases stiffness. Optionally, the crossmember may comprise a planar or substantially planar area, and one or more curved areas. The second face of the heat sink device may be coupled to the planar area or substantially planar area.

The crossmember (or "K-frame" or "K-member") may be any structural component that is fixed to (e.g., bolted to) and/or transverse to the main structure of a vehicle. The crossmember may be a metallic part and/or make the vehicle rigid from left to right. The crossmember may be formed as a metal sheet, and the second face of the heat sink device may be coupled to a face of the metal sheet. Such a crossmember forms a thermal conductor and therefore achieves high heat dissipation. The crossmember may be made of aluminium, steel or any other metallic material.

The TCU may be an embedded system onboard the vehicle that wirelessly connects the vehicle to cloud services or other vehicles over a cellular network. The TCU may be configured to collect telemetry data from the vehicle, such as position, speed, engine data, connectivity quality, etc., from various sub-systems over data and control busses. The TCU may comprise at least a main PCB on which a plurality of elements, antennas, sensors, controllers, and/or busses may be mounted.

In examples, the vehicle may be a car and the TCU may be installed inside the dashboard of the car. Installing the TCU in such an area can therefore provide for additional useable space inside the dashboard for other components, such as other components for placing upon the PCB. In other examples, the TCU may be installed inside or under a shark fin. Installing the TCU in such a location may improve the communication with the cloud services or networks as that is a location where the antennas work well. However, installing the TCU in such an area raises some difficulties as the rays from the sun may directly radiate the shark fin and consequently the TCU inside the shark fin could heat up and need to be cooled down to be able to function without any incident. In this example, the disclosed heat sink device therefore constitutes an improved solution as the heat dissipation provided allows the TCU comprising it, to be placed inside a vehicle shark fin. In yet other examples, the TCU may also be located under the roof. In these latter examples, the TCU may be sealed from the environment with some material such as glass, plastic, metal or any other type of material.

The heat sink device is now discussed in more detail.

In examples, the first face of the heat sink device may consist of a plain surface. In other words, the plurality of holes may not pierce the first face so that the first face is full and comprises no holes. In such a case, each hole of the plurality of holes is enclosed with the die-casting material of the heat sink device, with only one aperture formed on the second face. Such a structure allows maximal heat flow from the heat emitting part of the TCU into the heat sink device.

In examples, the plurality of holes may all have a same depth and/or reach a same distance from the first face. This facilitates manufacturing of the heat sink device. By "distance from the first face", it is meant the length between the first face and the extremity reached inside the heat sink device's material by a respective hole towards the first face. By "depth", it is meant the length of the hole from the second face towards the first face (i.e. , the distance until reaching the bottom of the hole, or, the first face in case of a through hole / non-plain first surface). When the second face is parallel to the first face, for example both faces being planar, the plurality of holes may (i) all have a same depth and (ii) reach a same distance from the first face.

In some embodiments, the first face of the heat sink device may occupy a lower area than the second face. In other words, the heat sink device is configured to gather heat emitted from a relatively small surface with the first face, and to spread said heat to a larger surface with the second face. This improves heat dissipation.

The area occupied by the first face may for example be the size of the heat emitting part of the TCU. Therefore, typical dimensions of the area occupied by the first face may depend on the dimensions of the heat emitting part. The heat emitting part may be square-shaped, for example between 20mm*20mm and 75mm*75mm, such as 42mm*42mm, or 50mm*50mm. In such an example, the area occupied by the first face also corresponds to the area comprising the plurality of holes within the second face of the heat sink device. Indeed, in this example, the second face of the heat sink device can be divided into two parts, a first part comprising a plurality of holes and a second part comprising no holes, preferably consisting of a plain surface. Typically, the second part of the second face borders the first part of the second face. In other words, the second part surrounds the first part of the second face. Consequently, the first face of the heat sink device may be centred relative to the second face.

In some embodiments, the heat sink device may be of a constant material thickness. This facilitates or enables die-casting of the heat sink device. This further improves heat transfer, as thickness irregularities such as due to material agglomeration may negatively impact heat conduction.

The constant material thickness may depend on the design, on the necessary heat exchange amount, and/or on other parameters. The constant material thickness may be between 1mm and 10mm, for example between 1.5mm and 5mm.

In some embodiments, the plurality of holes may all present a cross-section having a same and constant width. By "width", it is meant the smallest dimension of the cross-section. By "same and constant" width, it is meant that the width is the same along the depth of each hole, and the width is the same between the different holes. For example, each hole of the plurality of holes may have a rectangular parallelepiped shape. In this embodiment, the cross-section of each hole of the plurality of holes may for example be a square or a non-square rectangle. Such structure can be obtained as a direct result of die-casting, without having to machine the heat sink device (in order for example to remove uneven areas due to sink marks coming from material agglomeration).

In some embodiments, the constant material thickness of the heat sink device and the constant width of the cross-section of the plurality of holes may be equal. In other words, the holes present a shape having the same "thickness" as the material forming the heat sink device. In such embodiments, the die-cast is facilitated. Indeed, in such embodiments, the die-cast heat sink device notably solves feasibility issues due to too thick material on regular heat sinks. The die-cast heat sink device also removes or very likely reduces uneven areas due to sink marks without sacrificing too much the heat transfer.

If, in addition, each hole of the plurality of holes has a rectangular parallelepiped shape, the die-casting is further facilitated as such a shape reduces the risk of having material agglomeration inside the holes and thus prevents the need for additional milling. Material agglomeration would more likely occur with holes having round shapes for example. In other words, with a die-cast heat sink device having holes of a rectangular parallelepiped shape prevents the need to rework the holes by milling, which can otherwise be expensive and time consuming.

In some embodiments, the plurality of holes may form an array (on the second face). In other words, the plurality of holes may form a one-dimensional arrangement (single row) of holes. If, in addition, the heat sink device is of a constant material thickness and the plurality of holes all present a cross-section having a same and constant width, the plurality of holes may be regularly spaced along a longitudinal direction to follow a certain one-dimensional pattern. In this embodiment, the cross-section of each hole of the plurality of holes may be a non-square rectangle (e.g., with a length at least 2 or 5 times higher than the width).

In some embodiments, the plurality of holes may form a grid. In other words, the plurality of holes may form a two-dimensional arrangement (several offset rows) of holes. If, in addition, the heat sink device is of a constant material thickness and the plurality of holes all present a cross-section having a same and constant width, the plurality of holes may be regularly spaced along a longitudinal direction and along a lateral direction to follow a certain two-dimensional pattern. In this embodiment, the cross-section of each hole of the plurality of holes may be a square (with a length equal to the width) or a rectangle (e.g., with a length at most 2 or 1.5 times higher than the width).

Examples of the heat sink device are now discussed with reference to the figures. The heat sink device may optionally be die-cast and/or made of aluminium and/or any of the above-mentioned metals in such examples.

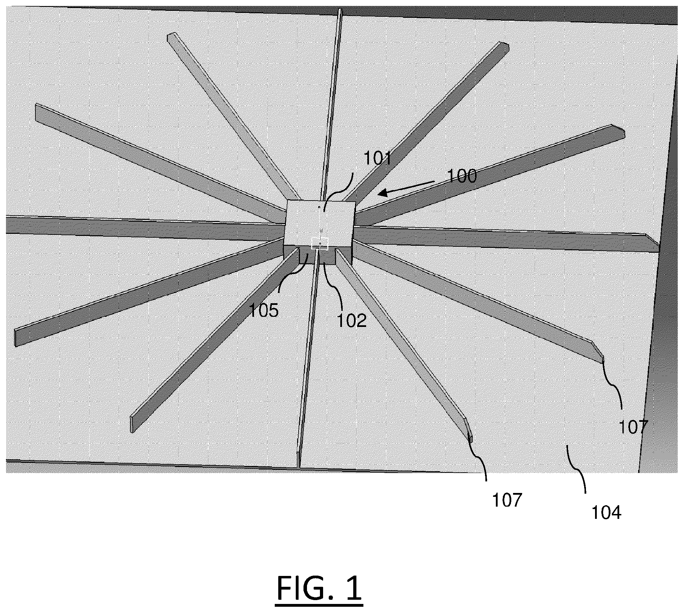

FIG. 1 shows an example of the heat sink device 100. The heat sink device 100 comprises the first face 101. The first face 101 is configured to be coupled to a heat emitting part of the TCU (not shown). The heat sink device 100 also comprises the second face 102. The second face is configured 102 to be coupled to a crossmember 104 of the vehicle. The crossmember is shown as a flat surface. The second face is opposite to the first face. Optionally, the second face 102 may comprise a plurality of holes extending from the second face 102 toward the first face 101 (not shown).

The heat sink device also comprises the at least one wall 105. The at least one wall 105 extending between the first face and the second face. The at least one wall 105 has a attached a plurality of ribs 107 extending outwardly from the heat sink.

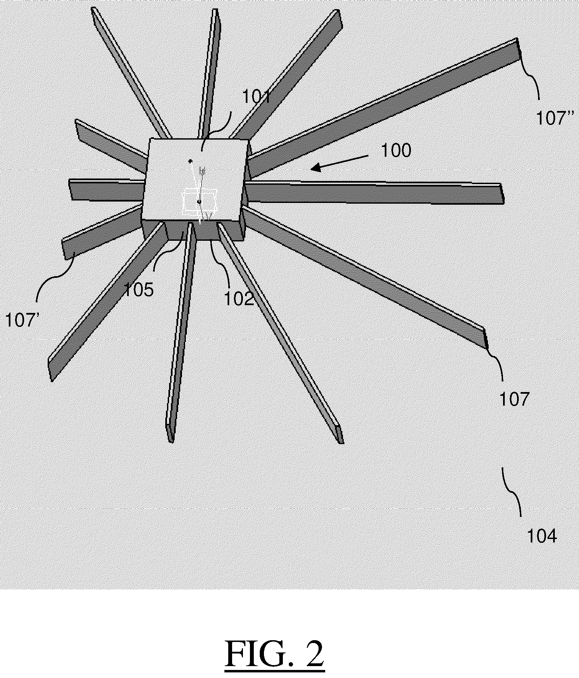

FIG. 2 illustrates another example of the heat sink device 100. Here, the ribs 107, 107', 107" may extend outwardly so as to fill the area of the housing comprised by the TCU, for example, the rib 107" is longer than the rib 107, which is longer than the rib 107'.

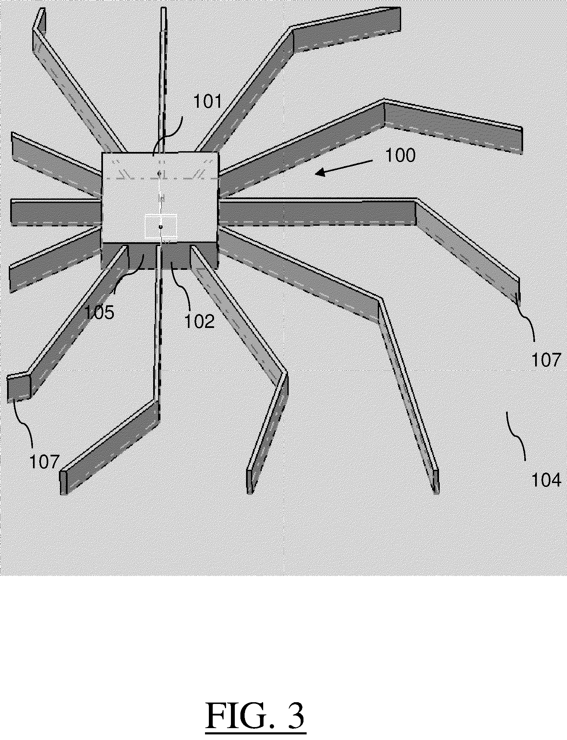

FIG. 3 illustrates another example of the heat sink device 100. In this example, the ribs 107, 107', 107" may extend outwardly following a spiral shape.

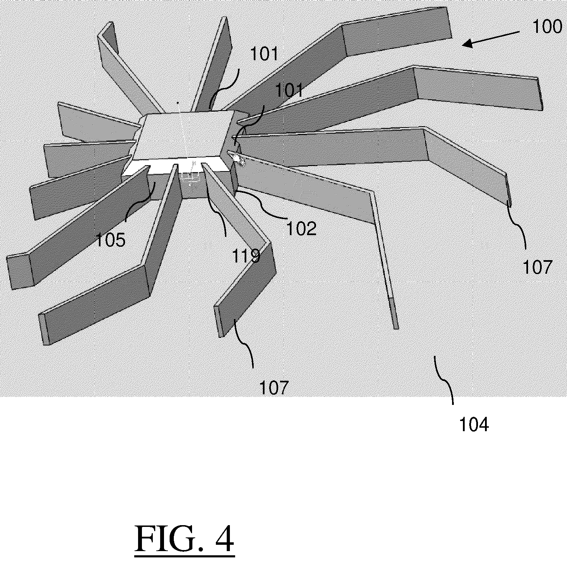

FIG. 4 illustrates another example of the heat sink device 100. In this example, the first face 101 has an area smaller than the second face 102. The wall 105 extends from the first face 101 to a portion of the second face 102. The portion of the second face has an area comprised between the area of the first face and the second face, e.g., the wall has a vertical element 110 linked to an angular shape 109. The angular shape 109 is connected to the first face 101 while the vertical element 110 is connected to the portion of the second face 102.

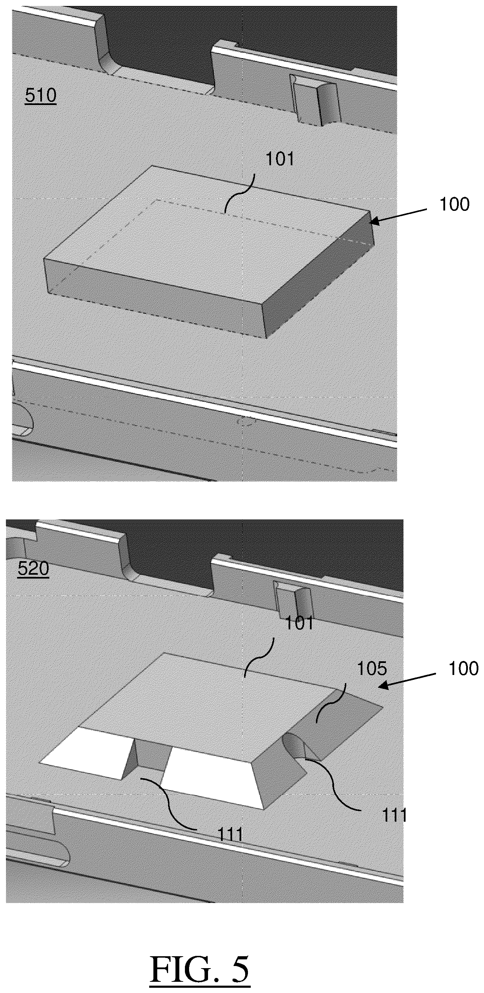

FIG. 5 illustrates a heatsink 510 without ribs. FIG. 5 also illustrates another example 520 of the heat sink device 100. In contrast to the heatsink 510, the heatsink 520 illustrates the wall 105 extending from the first face 101 to a portion of the second face 102. It is shown without ribs for the sake of illustration. The wall 105 also has gaps 111 positioned so as to free space for components of the telematic control unit.

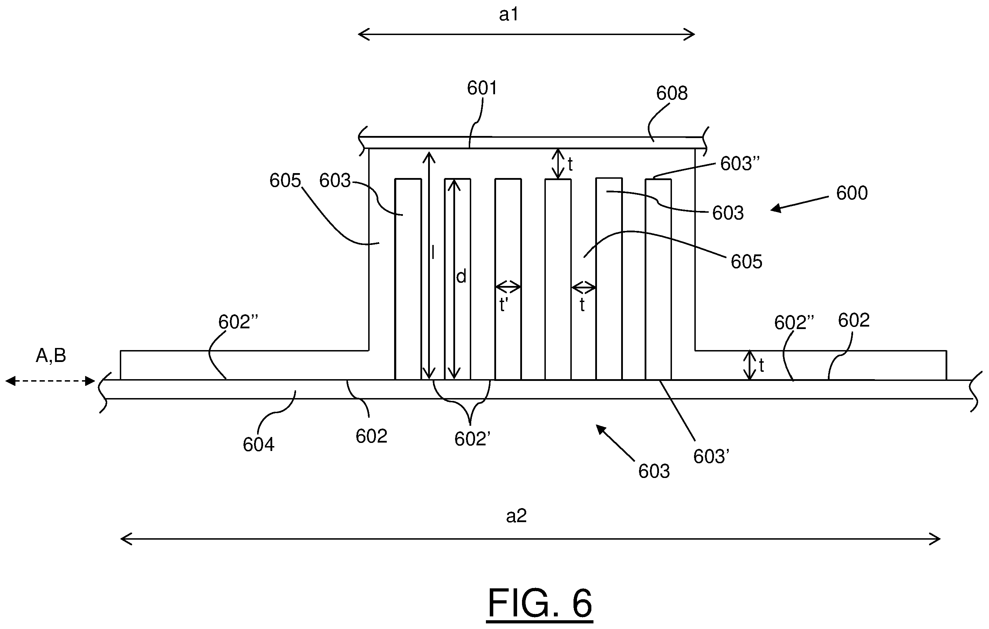

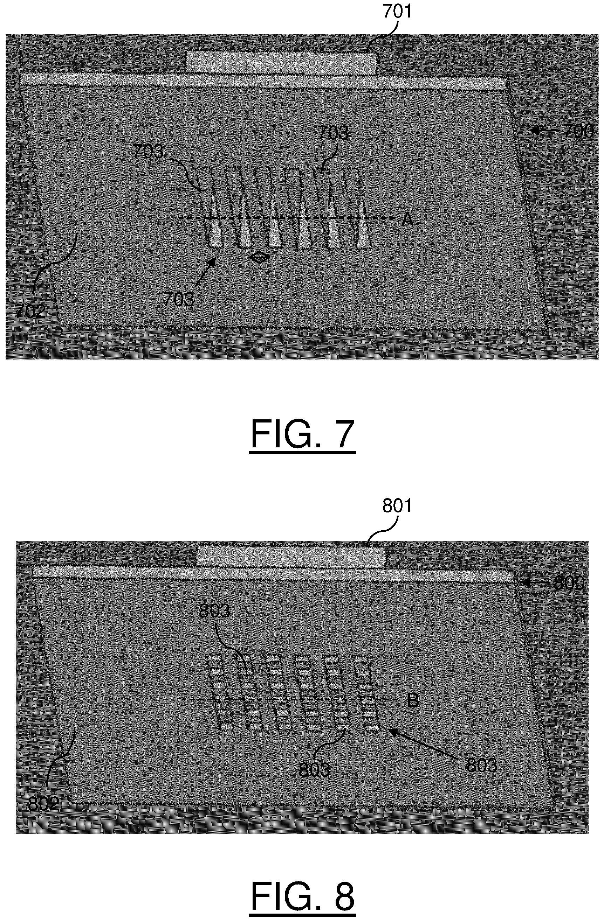

FIG. 6 shows a cross-sectional view of the holes extending towards the first face in the heat sink device 600. In this particular example, the plurality of ribs extending outwardly from the heat sink is not shown for the sake of simplicity. Moreover, the cross-section view may for example be indifferently taken along axis A of the example of FIG. 7, or along axis B of the example of FIG. 8.

The heat sink device 600 comprises in such examples a first face 601 coupled to a heat emitting part 608 of a TCU. The heat sink device 600 further comprises a second face 602 opposite to the first face 601 and coupled to a crossmember 604 of the vehicle. The second face 602 comprises a plurality of holes 603 extending from the second face 602 toward the first face 601.

The heat sink device 600 is made of a thermally conductive material and is thus configured for dissipating heat emitted from the heat emitting part 608 towards the crossmember 604. Thanks to thermal coupling, heat is conducted from the heat emitting part 608 into the heat sink device 600 through the first face 601, the heat emitting part 608 being in contact with the first face 601 (e.g., indirectly via a thermal paste or a thermal adhesive). The heat sink device 600 has at least one wall 605 600 that extends between the first face 601 and the second face 602. The at least one wall 605 has attached a plurality of ribs extending outwardly from the heat sink (not shown). Heat is finally flowed through the second face 602 into the crossmember 604, more specially though interfacing zones 602', 602" where the second face 602 is in contact with the crossmember 604 (e.g., indirectly via a thermal paste or a thermal adhesive).

Each hole 603 extends from an aperture 603' formed on the second face 602 towards the first face 601, and may stop at a bottom 603" of the hole 603. Each hole 603 thus forms an enclosed cavity with only one aperture 603'. The first face 601 may thereby be plain. This ensures maximal heat transfer from the heat emitting part 608 into the heat sink device 600.

The first face 601 may occupy a lower area a1 than the area a2 occupied by second face 602. In particular, the interfacing zones 602', 602" where the second face 602 is in contact with the crossmember 604, may include interfacing zones 602' facing the first face 601 and where the holes 603 are located, and interfacing zones 602" peripheral to the interfacing zones 602'. This improves heat dissipation towards the crossmember 604.

The plurality of holes 603 may all reach a same distance t from the first face 601 and/or have a same depth d, which may as shown on the figure be higher than 50% or 75% of the distance I between the first face 601 and the second face 602. Having lengthy holes 603 lowers the risks of having uneven areas due to sink marks or other material distribution defects on the heat sink device 600.

In fact, the heat sink device 600 may be of a constant material thickness t, such that that the distance reached from the first face 601 is equal to t, and d = I - t. The thickness of the heat sink device 100 in the at least one wall605 may thus be equal to the thickness of the material in region 605 and equal to the thickness of the interfacing zones 602". This facilitates die-casting of the heat sink device 600.

The holes 603 may each present a cross-section having a same and constant width t' (constant along the depth d of the hole 603). This again facilitates die-casting. The constant material thickness t may be equal to the width t', in other words t = t'. This yet facilitates die-casting, and optimizes the ratio between reduction of uneven areas due to sink marks and other defects, and maintenance of heat transfer capability.

This can be achieved by each hole 603 having a rectangular parallelepiped shape extending from the second face 602 towards the first face 601. Such structure of a heat sink device 600 having parallelepipedal cavities 603 may be obtained as a direct result of die-casting, with no or little post-moulding machining required to remove defects.

FIG. 7 shows a heat sink device 700 that may present a cross-sectional view along axis A that results in the view of FIG. 6. Similarly as in FIG. 6, in this particular example, the plurality of ribs extending outwardly from the heat sink is not shown for the sake of simplicity.

The heat sink device 700 comprises a first face 701 to be coupled to a heat emitting part (not shown here). The heat sink device 700 further comprises a second face 702 to be coupled to a crossmember of the vehicle (not shown here). The second face 702 comprises a plurality of holes 703.

Each hole 703 has a rectangular parallelepiped shape and the plurality of holes 703 forms an array on the second face 702. Here, the distance between each hole of the plurality of holes 603 is also the same as the width of the cross-section of the plurality of holes 603. The embodiment illustrated in FIG. 7 will be further referred to as case 2.

Face 701 and face 702 may be parallel, and each rectangular parallelepiped shaped hole 703 may extend perpendicularly to face 701 and face 702. The plurality of rectangular parallelepiped shaped holes 703 may be parallel one to another, and aligned so as to form a straight array, e.g. parallel to the length of face 701 and to the length of face 702, as shown on the figure.

FIG. 8 shows a heat sink device 800 that may present a cross-sectional view along axis B that results in the view of FIG. 6. Similarly as in FIG. 6, in this particular example, the plurality of ribs extending outwardly from the heat sink is not shown for the sake of simplicity.

Referring to FIG. 8, the heat sink device 800 comprises a first face 801 to be coupled to a heat emitting part (not shown here). The heat sink device 800 further comprises a second face 802 to be coupled to a crossmember of the vehicle (not shown here). The second face comprises a plurality of holes 803. Each hole of the plurality of holes 803 has a square parallelepiped shape, in other words, the cross-section of each hole of the plurality of holes 803 is a square. The plurality of holes 803 forms a 6x6 grid comprising six rows and six columns.

Face 801 and face 802 may be parallel, and each square parallelepiped shaped hole 803 may extend perpendicularly to face 801 and face 802. The plurality of rectangular parallelepiped shaped holes 803 may be parallel one to another, and aligned so as to form a rectangular grid, e.g. with a length of the rectangular grid parallel to the length of face 801 and to the length of face 802, and a width of the rectangular grid parallel to the width of face 801 and to the width of face 802, as shown on the figure.

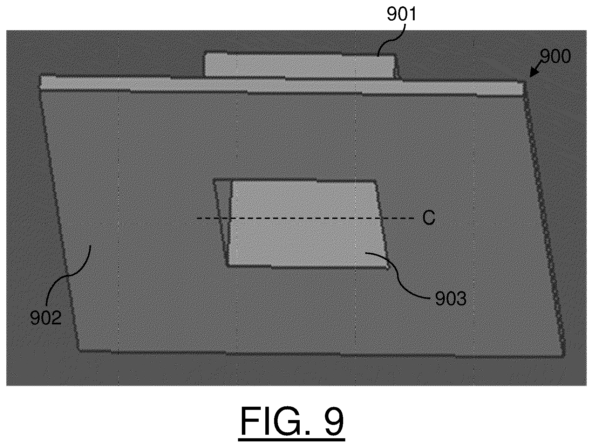

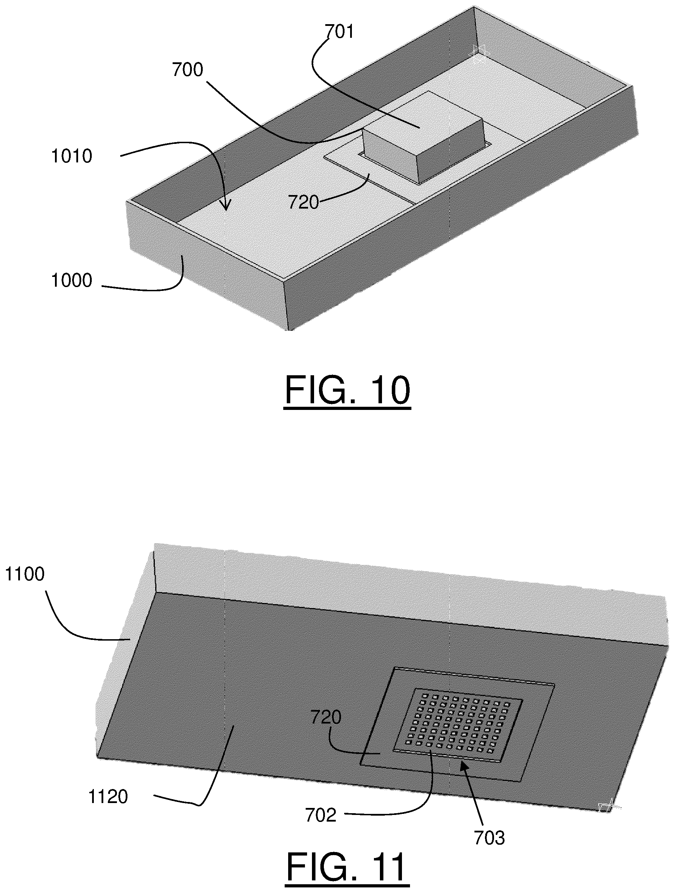

Referring to FIG. 9, a heat sink device 900 that differs from the heat sink device of the disclosure comprises a first face 901 to be coupled to a heat emitting part (not shown here). The heat sink device 900 further comprises a second face 902 to be coupled to a crossmember of the vehicle (not shown here). The second face comprises a single hole 903 instead of a plurality of holes.

FIG.s 10-11 show how a heat sink device of the present disclosure such as, as a non-limiting example, heat sink device 700 of FIG. 7, can be integrated to a TCU. The plurality of ribs extending outwardly from the heat sink is not shown for the sake of simplicity.

The heat sink device 700 may be attached to the housing 800 of a TCU via a peripheral edge 720 which may be integrally formed with the heat sink device 700 or with the housing 1000. The heat sink device 700 may be formed before forming the housing 1000, which may be made of plastic and/or moulded. The heat sink device 700 may be applied as an insert when moulding the housing 1000.

The heat sink device 700 may be arranged such that its second face 702 is substantially aligned with a face 1120 of the housing configured for being coupled to a crossmember (not shown), such that the second face 702 may also be coupled to the crossmember.

The plurality of holes 703 extends from the second face 702 towards a first face 701 of the heat sink device 700 formed in an interior 1110 of the housing, such that the first face 701 may be coupled to a heat emitting part (not shown) of the TCU.

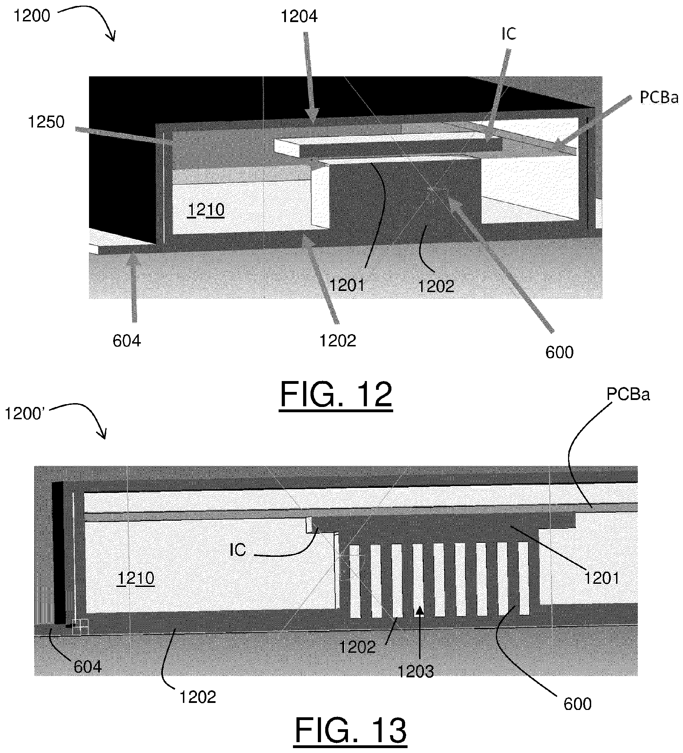

FIG. 12 shows a cross-sectional view of an example of a TCU 1200 including a heat sink device of the present disclosure such as, as a non-limiting example, heat sink device 100 of FIG. 1. The plurality of ribs extending outwardly from the heat sink is not shown for the sake of simplicity.

TCU 1200 comprises a housing including a lower housing part 1802 and an upper housing part 1204. The lower housing part 1202 is coupled to a crossmember 604 of the vehicle, which may be in metal. The housing 1202-1204 defines an interior 1210 of the TCU, which may lodge a printed circuit board assembly PCBa and an integrated circuit IC.

The heat sink device 600 has a first face 601 coupled to the IC indirectly, as the PCBa is arranged between the first face 601 and the IC. The first dace 601 may be coupled to the PCBa though thermal paste 1250.

The second face 602 of the heat sink device 600 is coupled to the crossmember 604. Heat emitted by the IC and/or by the PCBa may be dissipated by the heat sink device 600 towards the crossmember 604.

FIG. 13 shows a cross-sectional view of a TCU 1200' identical to TCU 1200 of FIG. 12, except that in this case, the PCBa and the IC are arranged inverted relative to FIG. 12, such that the first face 601 of the heat sink device 600 is directly coupled and in contact with the IC. The plurality of ribs extending outwardly from the heat sink is not shown for the sake of simplicity.

The second face 602 of the heat sink device 600 is coupled to the crossmember 604. Heat emitted by the IC and/or by the PCBa may be dissipated by the heat sink device 600 towards the crossmember 604, in the same way as in FIG. 13.

The plurality of holes 603 extending toward the first face 601, shown on FIG. 13 but not on FIG. 12, allow for a simple manufacturing by die-casting, which avoids or reduces the presence of uneven areas due to sink marks or other material distribution defects, such as material agglomeration, and thus avoiding or reducing the need to machine the heat sink device.

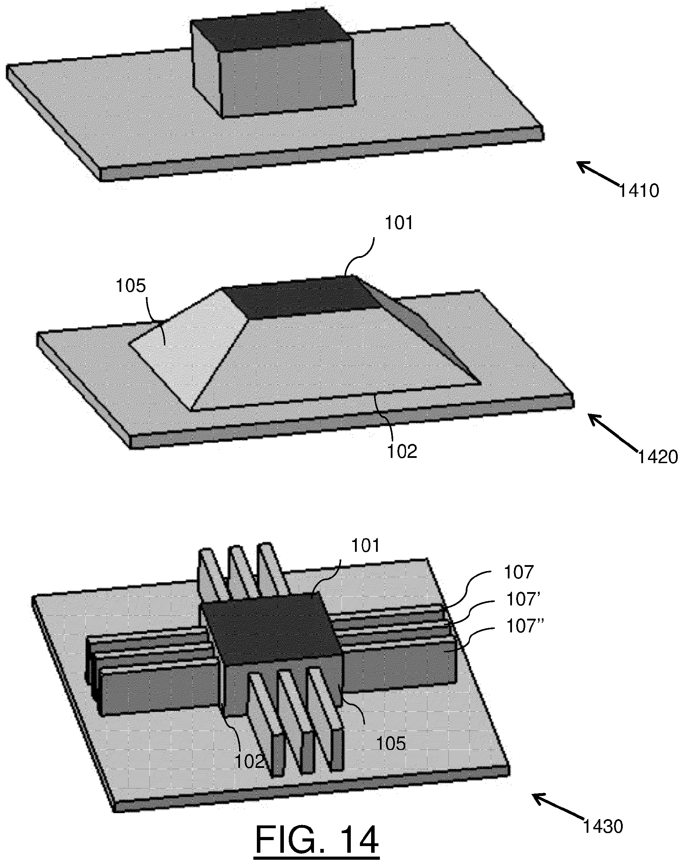

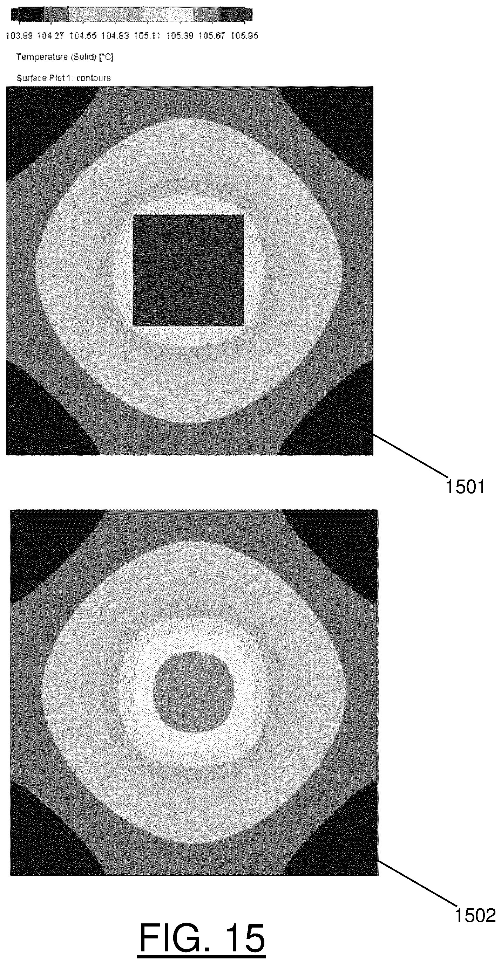

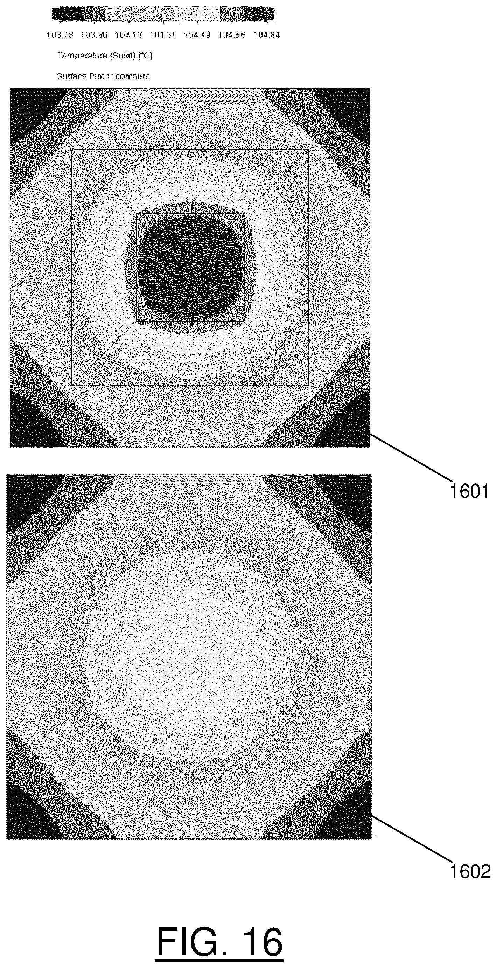

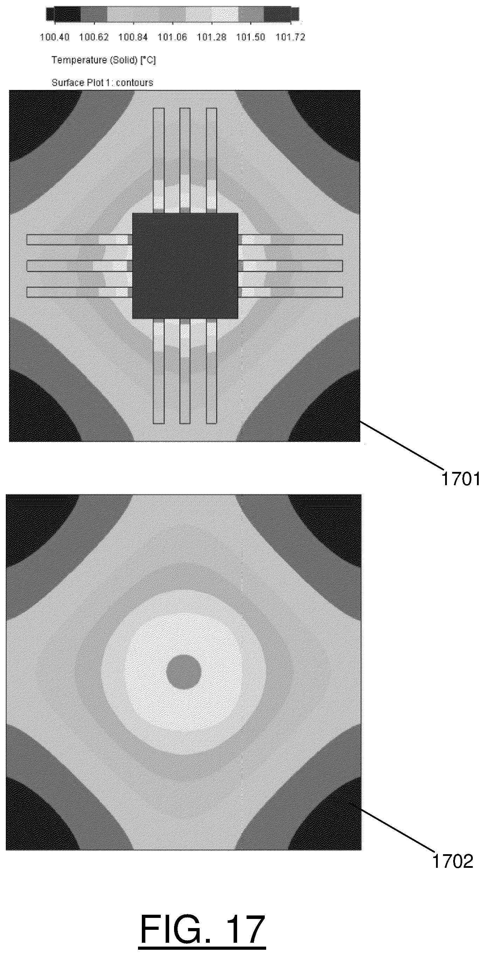

FIG. 14 shows examples of the heat sink device 1420, 1430 relative to a heat sink block 1410. The heat sink device 1420 comprises the first face 101. The first face 101 is configured to be coupled to a heat emitting part of the TCU (not shown). The heat sink device 100 also comprises the second face 102. The second face is configured 102 to be coupled to a crossmember 104 of the vehicle. The crossmember is shown as a flat surface. The second face is opposite to the first face. The second face 102 comprises a plurality of holes extending from the second face 102 toward the first face 101 (not shown).

In the heatsink device 1420, the first face 101 has an area smaller than the second face 102. The wall 105 extends from the first face to a portion of the second face 102. The portion of the second face 102 has an area comprised between the area of the first face 101 and the second face 102. As such, the wall 105 is shown extending diagonally from the first face to the portion of the second face.

In the heat sink device 1430, the at least one wall 105 extends between the first face and the second face. The at least one wall 105 has a attached a plurality of ribs 107, 107', 107" extending outwardly from the heat sink.

FIG.s 15 show simulations of heat spreading through the heat sink block 1410 over a top face 1501 and a lower face 1502. FIG.s 16 show simulations of heat spreading through the heat sink device 1420. The simulations show heat spreading through the first face 1601 and the second face 1602. FIG.s 16 show simulations of heat spreading through the heat sink device 1430. The simulations show heat spreading through the first face 1701 and the second face 1702.

The following table gathers the simulation results of FIG.s 15 to 17:

**Table I: Heat dissipation comparison with different heat sink devices**

| | Temperature of the first face | Temperature of the second face | Difference of temperature between the two sides |
|---|---|---|---|
| FIG. 15 | 105.9°C | 105.6°C | 0.3°C |
| FIG. 16 | 104.8°C | 104.6°C | 0.2°C |
| FIG. 17 | 101.7°C | 101.4°C | 0.3°C |

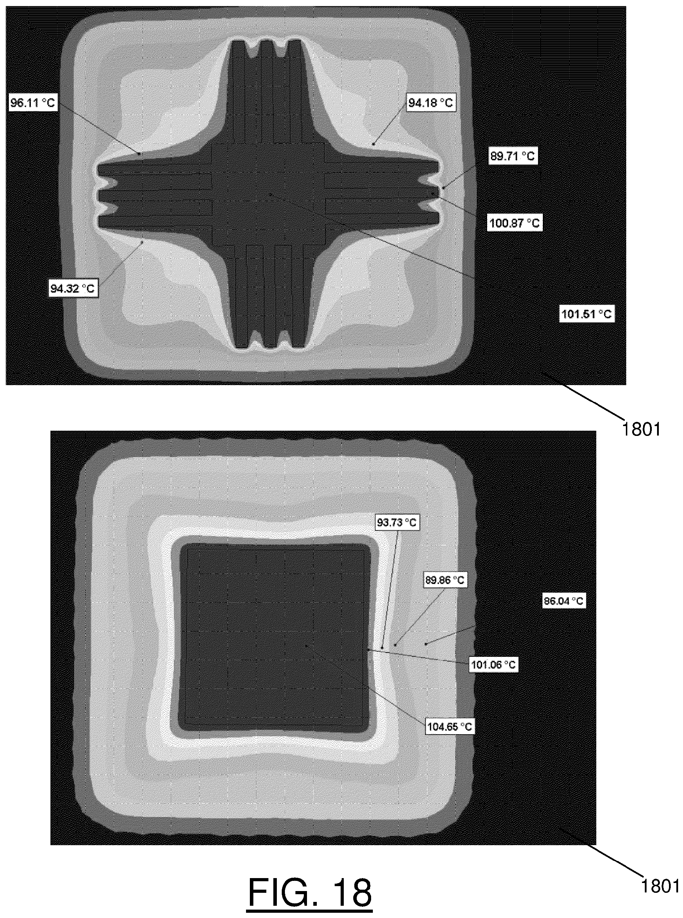

FIG 18 shows heat temperatures distributions 1801 and 1802 over the heat sink 1430. The heat temperature distribution 1801 show the temperature in a view over the first face 101. The heat temperature distribution 1802 shows the temperature in a view over the first face 102.

For the sake of comparison, simulations of the heat sink device only with the plurality of holes is now discussed.

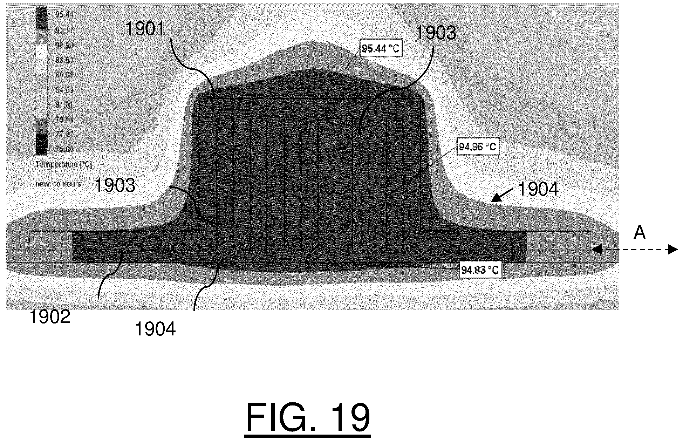

FIG. 19 shows the thermodynamic simulation of the heat sink device of FIG. 7. The second face 702 is shown coupled to a crossmember 704 of the vehicle, and the heat emitting part coupled to first face 701 is not shown. The temperature of the first face 701 is of 95.44°C and the temperature of the second face 702 is of 94.86°C. The difference in temperature between the two faces is of 0.58°C.

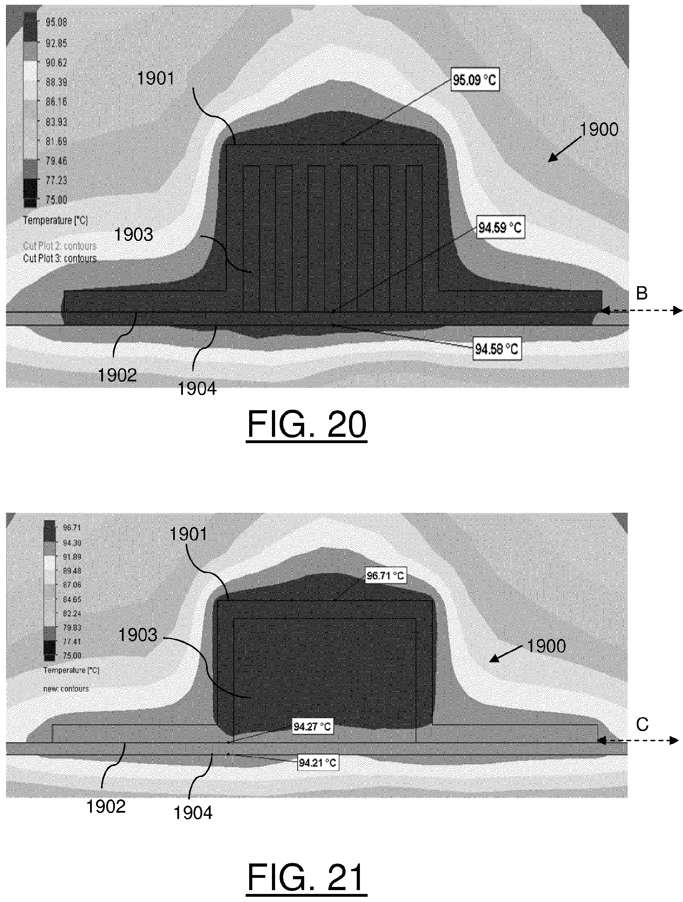

FIG. 20 shows the thermodynamic simulation of heat sink device of FIG. 8. The second face 802 is shown coupled to a crossmember of the vehicle 804, and the heat emitting part coupled to first face 801 is not shown. The temperature of the first face 801 is of 95.09°C and the temperature of the second face 802 is of 94.59°C. The difference in temperature between the two faces is of 0.50°C.

FIG. 21 shows the thermodynamic simulation of heat sink device of FIG. 9. The second face 902 coupled to a crossmember of the vehicle 904, and the heat emitting part coupled to first face 901 is not shown. The temperature of the first face 901 is of 96.71°C and the temperature of the second face 902 is of 94.27°C. The difference in temperature between the two faces is of 2.44°C.

The following table gathers the simulation results of FIG.s 19 to 21:

**Table II: Heat dissipation comparison with different heat sink devices**

| | Temperature of the first side | Temperature of the second side | Difference of temperature between the two sides |
|---|---|---|---|
| FIG. 19 | 95.44°C | 94.83°C | 0.58°C |
| FIG. 20 | 95.09°C | 94.59°C | 0.50°C |
| FIG. 21 | 96.71°C | 94.27°C | 2.44°C |

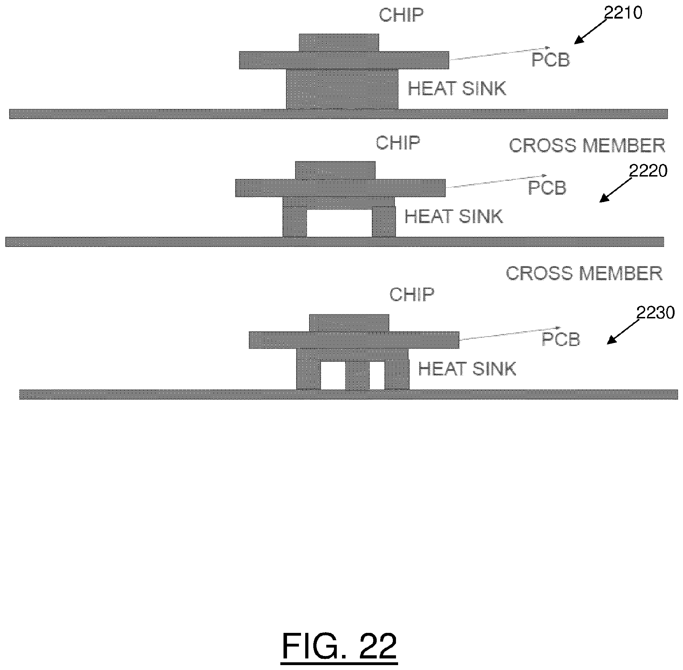

FIG. 22 shows alternatives 2210, 2220, 2230 of the disposition of the heatsink relative to the crossmember of the vehicle and a heat emitting part of the telematic control unit, a chip mounted to a PCB.

## Claims

1. A heat sink device configured to dissipate heat of a vehicle telematic control unit, comprising:
- a first face configured to be coupled to a heat emitting part of the telematic control unit;
- a second face configured to be coupled to a crossmember of the vehicle, the second face being opposite to the first face, and
- at least one wall extending between the first face and the second face, the at least one wall having a attached a plurality of ribs extending outwardly from the heat sink.

2. The heat sink device according to claim 1, the first face having an area smaller than the second face, the wall extending from the first face to a portion of the second face, the portion of the second face having an area comprised between the area of the first face and the second face.

3. The heat sink device according to claim 1 or 2, wherein the ribs extend outwardly so as to free space for components of the telematic control unit.

4. The heat sink device according to any one of claims 1 to 3, wherein the first face consists of a plain surface and/or the heat sink device is of a constant material thickness (t).

5. The heat sink device according to any one of claims 1 to 4, wherein the second face comprises a plurality of holes, the plurality of holes extending towards the first face.

6. The heat sink device according to any one of claims 1 to 5, wherein the plurality of holes all reach a same distance (t) from the first face.

7. The heat sink device according to any one of claims 1 to 6, wherein the plurality of holes each present a cross-section having a same and constant width (t').

8. The heat sink device according to any one of claims 1 to 7, wherein the heat sink device is of a constant material thickness (t), and the constant material thickness (t) is equal to the width (t') of the cross-section of each hole of the plurality of holes.

9. The heat sink device according to any one of claims 1 to 8, each hole of the plurality of holes has a rectangular parallelepiped shape.

10. The heat sink device according to any one of claims 1 to 9, wherein the plurality of holes forms an array on the second face.

11. The heat sink device according to any one of claims 1 to 10, wherein the plurality of holes forms a grid on the second face.

12. The heat sink device according to any one of claims 1 to 11, wherein the heat sink device is die-cast.

13. A vehicle telematic control unit comprising:
- a heat emitting part; and
- a heat sink device according to any one of claims 1 to 12, the first face of the heat sink device being coupled to the heat emitting part.

14. The vehicle telematic unit of claim 13, wherein the heat emitting part comprises one or more processors and/or one or more printed circuit boards (PCBs).

15. A vehicle comprising:
- a vehicle telematic control unit according to claim 13 or 14; and
- a crossmember, the second face of the heat sink device being coupled to the crossmember.
